(19) Europäisches Patentamt
European Patent Office
Office européen des brevets

(11) **EP 3 559 683 B1**

(12) **EUROPEAN PATENT SPECIFICATION**

(45) Date of publication and mention
of the grant of the patent:
**25.01.2023 Bulletin 2023/04**

(51) International Patent Classification (IPC):
***G01R 15/18*** *(2006.01)*     ***G01R 19/25*** *(2006.01)*
***H03H 17/04*** *(2006.01)*

(21) Application number: **17829088.8**

(52) Cooperative Patent Classification (CPC):
**G01R 15/181;** G01R 19/2506; H03H 17/04

(22) Date of filing: **18.12.2017**

(86) International application number:
**PCT/US2017/066922**

(87) International publication number:
**WO 2018/118737 (28.06.2018 Gazette 2018/26)**

(54) **CURRENT SENSING CIRCUITS AND METHODS OF IMPLEMENTING A DIGITAL INTEGRATOR**

STROMMESSSCHALTUNGEN UND VERFAHREN ZUR IMPLEMENTIERUNG EINES DIGITALEN INTEGRATORS

CIRCUITS DE DÉTECTION DE COURANT ET PROCÉDÉS DE RÉALISATION D'UN INTÉGRATEUR NUMÉRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.12.2016 US 201615386063**

(43) Date of publication of application:
**30.10.2019 Bulletin 2019/44**

(73) Proprietor: **Eaton Intelligent Power Limited**
**Dublin 4 (IE)**

(72) Inventors:
• **GAO, Zhi**
**Warrendale**
**Pennsylvania 15086 (US)**
• **HOSKO, Daniel A.**
**Pittsburgh**
**Pennsylvania 15202 (US)**

• **MILLER, Theodore J.**
**Oakdale**
**Pennsylvania 15071 (US)**

(74) Representative: **Novagraaf Group**
**Chemin de l'Echo 3**
**1213 Onex/ Geneva (CH)**

(56) References cited:
EP-A1- 3 296 752        WO-A2-01/82675
DE-A1-102012 107 021        DE-A1-102015 216 981
US-B1- 6 624 745

• **FAIFER M ET AL: "An Electronic Current Transformer Based on Rogowski Coil", 2008 IEEE INSTRUMENTATION AND MEASUREMENT TECHNOLOGY CONFERENCE : [I2MTC 2008] ; VICTORIA, BC, CANADA, 12 - 15 MAY 2008, IEEE, PISCATAWAY, NJ, USA, 12 May 2008 (2008-05-12), pages 1554-1559, XP031274850, ISBN: 978-1-4244-1540-3**

**Description**

BACKGROUND

Field

The disclosed concept relates generally to circuits, and in particular, to a current sensing circuit for resolving current from the output of a Rogowski coil.

Background Information

Accurate measurement of electrical current is important to numerous protection, metering, and control applications. Among numerous electrical current measurement technologies, Rogowski coil based current sensing technology has been widely used to measure alternating current (AC) or high speed current pulses in protection, metering, and monitoring applications.

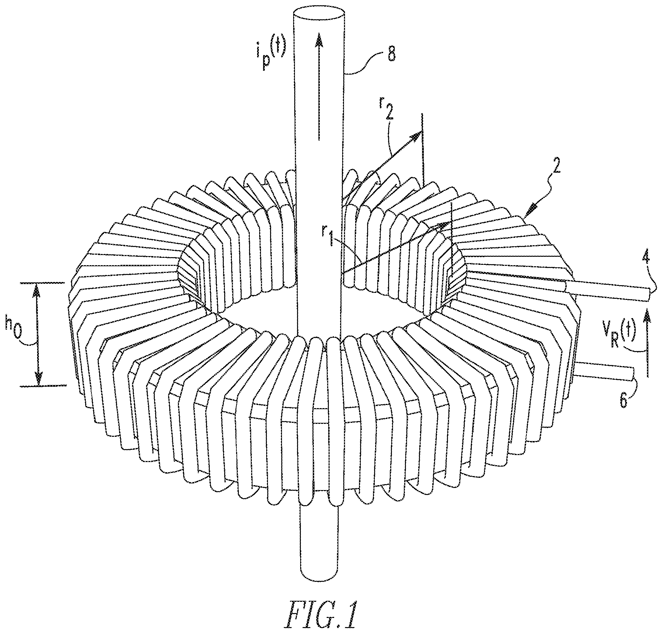

FIG. 1 is an isometric view of a Rogowski coil 2. The Rogowski coil 2 includes coils wound over a non-magnetic core. As a result, the Rogowski coil does not saturate and offers a wide operating current range. The Rogowski coil 2 is arranged for use in sensing a current $i_P(t)$ flowing through a conductor 8. The output of the Rogowski coil 2 is a voltage $v_R(t)$ between its output terminals 4,6.

FIG . 2 is a circuit diagram of current sensing circuitry used with the Rogowski coil 2 of FIG. 1. The current sensing circuitry includes terminals 10,12 that connect to the output terminals 4,6 of the Rogowski coil 2 of FIG. 1. The voltage $v_R(t)$ is realized between the terminals 10, 12. Ferrite beads 14, 16 are electrically connected to the terminals 10,12 and suppress high frequency noise in the voltage $v_R(t)$. Outputs of the ferrite beads 14, 16 are electrically connected to a resistor-capacitor-resistor shunt path including two resistors 18,20 and a capacitor 22. The two resistors 18,20 and the capacitor 22 constitute an RC-filter that acts as an analog integrator. An instrumentation amplifier 24 is electrically connected across the capacitor 22. The output voltage $v_o(t)$ of the instrumentation amplifier 24 is proportional to the current $i_P(t)$ flowing through the conductor 8.

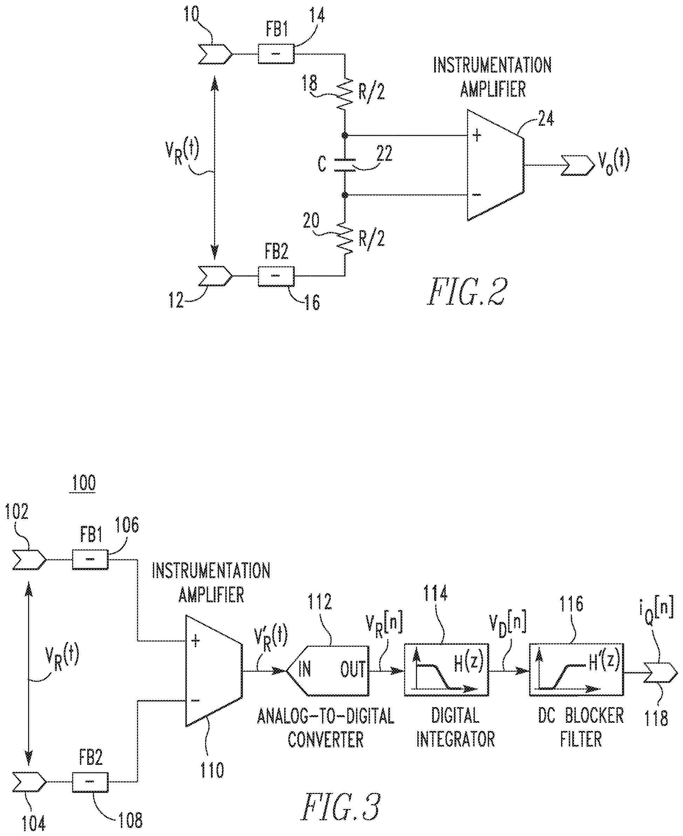

There are some challenges with using the current sensing circuitry of FIG. 2 to resolve the current $i_P(t)$ flowing through the conductor 8 of FIG. 1. First, it is difficult to resolve the current $i_P(t)$ from the relatively small output voltage $v_R(t)$ of the Rogowski coil 2. Second, it is difficult to cope with large temperature variations, which frequently occur in circuit breaker operation.

As previously noted, the Rogowski coil 2 includes a non-magnetic core. Due to the non-magnetic core, the mutual coupling between the Rogowski coil 2 and the conductor 8 is small compared to the mutual coupling between a conductor and a current sensing element with a magnetic core such as a current transformer. This results in a small output voltage $v_R(t)$ for the Rogowski coil 2. Moreover, the use of an analog integrator, as is used in the current sensing circuitry of FIG. 2, aggravates the situation. Compared to the output voltage $v_R(f)$ of the Rogowski coil 2, the output voltage $v_o(t)$ of the instrumentation amplifier 24 is even smaller. Small voltages have smaller signal to noise ratios (SNR) than larger voltages. Therefore, the small voltages are more susceptible to noise and can cause difficulties when high precision is needed, such as in metering and control applications.

Table 1 shows a relationship between operating temperature and coil resistance for a Rogowski coil, such as the Rogowski coil 2 of FIG. 1.

TABLE 1

| Operating Temperature (°C) | Coil Resistance (Ω) |
|---|---|
| 24.4 | 102.08 |
| 40 | 108.55 |
| 60 | 116.52 |
| 80 | 124.25 |
| 100 | 131.92 |
| 120 | 139.63 |
| 140 | 147.56 |
| 160 | 155.30 |
| 180 | 162.83 |

As shown in Table 1, variations in temperature cause changes in the coil resistance of a Rogowski coil. If the current sensing circuitry of FIG. 2 is integrated with the Rogowski coil, properties of components of the current sensing circuitry of FIG. 2, such as resistances of the two resistors 18,20, can also change due to variations in temperature. The variations in properties of the current sensing circuitry can make it difficult to accurately measure current. The temperature inside some circuit breakers can reach 160°C, so it is difficult to use the current sensing circuitry of FIG. 2 to accurately measure current in such an application.

Attention is drawn to DE 10 2012 107 021 A1, which shows a device which comprises a current channel for determining a current signal of a conductor, and a voltage channel for determining a voltage signal of the conductor assigned to the current signal. An analog to digital converter is arranged in the voltage channel for converting the voltage signal into a time-discrete voltage signal.

DE 10 2015 216 981 A1 is related to a circuit breaker for a low-voltage circuit, which comprises a current conductor, to which a measuring transformer for measuring the electrical current of the current conductor is assigned, a first filter connected to the measuring transformer, an analog-digital converter connected to the filter, a second high-pass filter connected to the analog-digital converter, and a digital integrator connected to the high-pass filter, for determining the electrical current of the current conductor.

FAIFER M ET AL: "An Electronic Current Transformer Based on Rogowski Coil", TECHNOLOGY CONFERENCE; 12-15 May 2008, XP031274850, ISBN: 978-1-4244-1540-3, is related to the study and the development of new measurement systems for high-voltage networks. In this paper a current transformer based on Rogowski coils for high voltage systems is presented.

WO 01 82 675 A2 is related to a method and/or apparatus for measuring current in a high voltage (HV) current carrier which generates a low voltage signal proportional to the current in the HV carrier and applies this signal to an integrated-optic voltage sensor located in the HV environment adjacent to the HV current carrier to produce a modulated optical signal representative of the current being measured. The optical signal from the integrated-optic voltage sensor is conducted to a low voltage (LV) environment insulated from said HV environment and processed to provide a second electrical signal. One of the electrical signals is integrated.

Further, US 6 624 745 B1 is related to a low pass filter which is configured for coupling home PNA network signals to a customer premises system having a two-wire European Installation Bus. The low pass filter uses an inductor having terminal ends connected to windings.

There is room for improvement in current sensing circuitry.

SUMMARY

These needs and others are met by embodiments of the disclosed concept in which a current sensing circuit includes a digital integrator.

In accordance with the present invention, apparatus as set forth in claims 1 and 2, and methods as set forth in claims 7 and 8, respectively, are provided. Further embodiments are inter alia disclosed in the dependent claims. In accordance with one aspect of the disclosed concept, a current sensing circuit for use with a Rogowski coil arranged around a conductor having a primary current comprises: input terminals structured to receive an output voltage of the Rogowski coil; filtering elements structured to filter high frequency voltage from the output voltage and to output a filtered output voltage; an amplifier structured to receive the filtered output voltage and produce a differential voltage; an analog to digital converter structured to convert the differential voltage to a digital differential voltage signal; a digital integrator structured to receive the digital differential voltage signal, to implement a discrete-time transfer function that is a transform of a transfer function of an analog integrator, and to output a digital integrator output signal; a direct current blocker filter structured to remove a direct current bias from the digital integrator output signal and to output a digital current output signal that is proportional to the primary current in the conductor.

In accordance with another aspect of the disclosed concept, a method of implementing a digital integrator comprises providing a sampling frequency $f_s$; providing a rated supply frequency $f_e$; providing a phase difference number of samples $\Delta n$; obtaining a power grid's normalized angular frequency at rated condition using the following equation:

$$\omega_e = 2\pi \frac{f_e}{f_s}$$

obtaining a first coefficient $a_1$ based on the following equation:

$$a_1 = \frac{\cos(\Delta n \cdot \omega_e)}{\cos[(\Delta n - 1) \cdot \omega_e]}$$

obtaining a second coefficient based on the following equation:

$$b_0 = \sqrt{1 - 2a_1 \cos\omega_e + a_1^2}$$

implementing the digital integrator as a digital filter using the first coefficient $a_1$ and the second coefficient $b_0$.

In accordance with another aspect of the disclosed concept, a method of implementing a digital integrator comprises; providing a sampling frequency $f_s$; providing a rated supply frequency $f_e$; providing a phase difference number of samples $\Delta n$; obtaining a power grid's normalized angular frequency at rated condition using the following equation:

$$\omega_e = 2\pi \frac{f_e}{f_s}$$

obtaining a first coefficient $a_1$ based on the following equation:

$$a_1 = \frac{\cos\left[\left(\Delta n + \frac{1}{2}\right) \cdot \omega_e\right]}{\cos\left[\left(\Delta n - \frac{1}{2}\right) \cdot \omega_e\right]}$$

obtaining a second coefficient $b_0$ and a third coefficient $b_1$ based on the following equation:

$$b_0 = b_1 = \sqrt{\frac{1 - 2a_1 \cos\omega_e + a_1^2}{2 \cdot (1 + \cos\omega_e)}}$$

implementing the digital integrator as a digital filter using the first coefficient $a_1$, the second coefficient $b_0$, and the third coefficient $b_1$.

BRIEF DESCRIPTION OF THE DRAWINGS

A full understanding of the disclosed concept can be gained from the following description of the preferred embodiments when read in conjunction with the accompanying drawings in which:

FIG. 1 is an isometric view of a Rogowski coil,
FIG. 2 is a circuit diagram of a current sensing circuit used with the Rogowski coil of FIG. 1;
FIG. 3 is a circuit diagram of a current sensing circuit in accordance with an example embodiment of the disclosed concept;
FIG. 4 is a graph of waveforms of a primary current, an output voltage of a Rogowski coil, and a primary current signal;
FIG. 5 is a flowchart of a method of determining coefficients of a digital integrator in accordance with an example embodiment of the disclosed concept;
FIG. 6 is a flowchart of another method of determining coefficients of a digital integrator in accordance with an example embodiment of the disclosed concept;
FIG. 7a is a signal flow graph of a digital biquadratic filter in accordance with an example embodiment of the disclosed concept;
FIGS. 7b and 7c are signal flow graphs of digital integrators implemented in a digital biquadratic filter in accordance with example embodiments of the disclosed concept; and
FIG. 7d is a signal flow graph of a DC blocker filter implemented in a digital biquadratic filter in accordance with an example embodiment of the disclosed concept.

## DESCRIPTION OF THE PREFERRED EMBODIMENTS

Directional phrases used herein, such as, for example, left, right, front, back, top, bottom and derivatives thereof, relate to the orientation of the elements shown in the drawings and are not limiting upon the claims unless expressly recited therein.

As employed herein, the term "processor" shall mean a programmable analog and/or digital device that can store, retrieve, and process data; a computer; a workstation; a personal computer; a microprocessor; a microcontroller; a microcomputer; a central processing unit; a mainframe computer; a mini-computer; a server; a networked processor; or any suitable processing device or apparatus.

As employed herein, the statement that two or more parts are "coupled" together shall mean that the parts are joined together either directly or joined through one or more intermediate parts.

FIG. 3 is a circuit diagram of current sensing circuitry 100 in accordance with an example embodiment of the disclosed concept. The current sensing circuitry 100 is structured to receive as input the output voltage of a Rogowski coil such as, for example and without limitation, the output voltage $v_R(t)$ of the Rogowski coil 2 of FIG. 1. The current sensing circuitry 100 includes first and second input terminals 102,104. The first and second input terminals 102,104 may be electrically connected to output terminals of a Rogowski coil such as the output terminals 4,6, of the Rogowski coil 2 of FIG. 1. Together, the current sensing circuitry 100 and the Rogowski coil 2 form a current sensing assembly.

The current sensing circuitry 100 further includes first and second filters 106,108. The first and second filter 106, 108 are respectively electrically connected to the first and second input terminals 102,104. in some example embodiments of the disclosed concept, the first and second filters 106,108 are filters structured to filter out high frequency voltage received through the first and second input terminals 102,104. In some example embodiments of the disclosed concept, the first and second filters 106,108 are ferrite beads. However, it will be appreciated by those having ordinary skill in the art that other types of filters may be employed as the first and second filters 106,108 without departing from the scope of the disclosed concept.

Outputs of the first and second filters 106,108 are electrically connected to an amplifier 110. The amplifier 110 is structured to produce a differential voltage $v_R(t)$ from the output of the first and second filters 106,108, The differential voltage $v'_R(t)$ is a floating voltage that is the difference between the outputs of the first and second filters 106,108. The output of the amplifier 110 is electrically connected to an analog to digital converter (ADC) 112. The ADC 112 is structured to convert the differential voltage $v'_R(t)$ into a digital differential voltage signal $v_R[n]$ in a discrete-time domain.

The output of the ADC 112 is provided to a digital integrator 114 and the ADC 112 is structured to provide the digital differential voltage signal $v_R[n]$ to the digital integrator 114. The digital integrator 114 is structured to integrate the digital differential voltage signal $v_R[n]$ to produce a digital integrator output signal $v_D[n]$.

In example embodiments of the disclosed concept, the digital integrator 114 implements a transfer function that is a discrete-time transform of the transfer function of an analog integrator. For example and without limitation, the digital integrator 114 may implement a discrete-time transform of the transfer function of the analog integrator formed by the resistors 18,20 and capacitor 22 of the current sensing circuit of FIG. 2. For example, the transfer function of the analog integrator of FIG. 2 in the s-domain is shown in Equation 1:

$$H(s) = \frac{V_o(s)}{V_R(s)} = \frac{1}{1 + sCR} = \frac{\frac{1}{RC}}{s + \frac{1}{RC}} = \frac{\alpha}{s + \alpha}$$

$$(\text{Eq. 1})$$

In Equation 1, H(s) is the transfer function of the analog integrator in the s-domain, $V_o(s)$ is the output of the instrumentation amplifier 24 in the s-domain and $V_R(s)$ is the output voltage of the Rogowski coil 2 in the s-domain. The capacitor 22 has a capacitance of C and the resistors 18,20 each have a resistance of R/2. $\alpha = \frac{1}{RC}$.

In some example embodiments of the disclosed concept, the digital integrator 114 implements a discrete-time transform of the transfer function of an analog integrator obtained using an impulse-invariant transform. Using the analog integrator of FIG. 2 as an example, the inverse Laplace transform of the analog integrator's transfer function (H(s) shown in Equation 1) is shown in Equation 2.

$$h_a(t) = \alpha \cdot e^{-\alpha t} \cdot u(t)$$

$$(\text{Eq. 2})$$

In Equation 2, $h_a(t)$ is the analog integrator's transfer function in the continuous-time domain, and u(t) is a unit step function. The discrete-time impulse response $h_d[n]$ of the analog integrator is shown in Equation 3. The quantity $T_S$ denotes a sampling interval, n denotes a temporal index, i.e., the nth sample in a discrete-time system.

$$h_d[n] = T_S \cdot h_a(nT_S)$$

$$(\text{Eq. 3})$$

Equation 4 shows the result of substituting the analog integrator's transfer function in the continuous-time domain $h_a(t)$ into Equation 3.

$$h_d[n] = \alpha \cdot T_S \cdot e^{-\alpha nT_S} \cdot u[n]$$

$$(\text{Eq. 4})$$

Applying the z-transform to the discrete-time impulse response $h_d[n]$ shown in Equation 4 results in the discrete-time transfer function H(z) shown in Equation 5.

$$H(z) = \frac{y(z)}{x(z)} = \frac{\alpha \cdot T_S}{1 - e^{-\alpha T_S} z^{-1}} = \frac{b_0}{1 - a_1 z^{-1}}$$

$$(\text{Eq. 5})$$

In Equation 5, x(z) and y(z) are the digital integrator's 114 input and output, respectively. In Equation 5, $a_1 = e^{-\alpha T_S} = e^{-\frac{T_S}{RC}}$ and $b_0 = \alpha \cdot T_S$. $z^{-1}$ denotes a one-sample delay. The discrete-time transfer function H(z) shown in Equation 5 is a discrete-time transformation of the transfer function of the analog integrator of FIG. 2 obtained using an impulse-invariant transform. In some example embodiments of the disclosed concept, the digital integrator 114 implements the discrete-time transfer function H(z) shown in Equation 5.

In some example embodiments of the disclosed concept, the digital integrator 114 implements a discrete-time transform of the transfer function of an analog integrator obtained using a bilinear transform. Equation 6 is a discrete-time approximation.

$$\frac{2}{T_s} \cdot \frac{1 - z^{-1}}{1 + z^{-1}}$$

$$(\text{Eq. 6})$$

Substituting s in Equation 1 with the discrete-time approximation shown in Equation 6 results in the discrete-time transfer function H(z) shown in Equation 7.

$$H(z) = \frac{y(z)}{x(z)} = \frac{\frac{\alpha T_s}{2+\alpha T_s} + \frac{\alpha T_s}{2+\alpha T_s}z^{-1}}{1 - \frac{2-\alpha T_s}{2+\alpha T_s}z^{-1}} = \frac{b_0 + b_1 z^{-1}}{1 - a_1 z^{-1}}$$

$$(\text{Eq. 7})$$

In Equation 7, $a_1 = \frac{2-\alpha T_s}{2+\alpha T_s}$ and $b_0 = b_1 = \frac{\alpha T_s}{2+\alpha T_s}$. The discrete-time transfer function H(z) shown in Equation 7 is a discrete-time transformation of the transfer function of the analog integrator of FIG. 2 obtained using a bilinear transform. In some example embodiments of the disclosed concept, the digital integrator 114 implements the discrete-time transfer function H(z) shown in Equation 7.

According to Equation 5, the digital integrator 114 has coefficients $a_1$ and $b_0$. In some example embodiments of the disclosed concept, the coefficients $a_1$ and $b_0$ are set based on the digital integrator's 114 phase delay.

In an example embodiment of the disclosed concept, the coefficients $a_1$ and $b_0$ of the digital integrator 114 implements a discrete-time transfer function that is an impulse-invariant transform of the transfer function of an analog integrator (e.g., without limitation, the discrete-time transfer function H(z) shown in Equation 5) and the coefficients $a_1$ and $b_0$ a set based on the phase delay of the digital integrator 114.

To compute the coefficients $a_1$ and $b_0$ in this example embodiment, it is useful to first compute the amplitude and phase response of the digital integrator 114. Equation 8 is the frequency response of the discrete-time transfer function H(z) of Equation 5 when z is replaced with $e^{j\omega}$.

$$H(e^{j\omega}) = \frac{b_0}{1 - a_1 e^{-j\omega}} = \frac{b_0 \cdot (1 - a_1 \cos\omega - j \cdot a_1 \sin\omega)}{1 - 2a_1 \cos\omega + a_1^2}$$

$$(\text{Eq. 8})$$

From Equation 8, the digital integrator's 114 amplitude response $A(\omega)$ and phase response $\varphi(\omega)$ may be obtained. The amplitude response $A(\omega)$ is shown in Equation 9 and the phase response $\varphi(\omega)$ is shown in Equation 10.

$$A(\omega) = |H(e^{j\omega})| = \frac{b_0}{\sqrt{1 - 2a_1 \cos\omega + a_1^2}}$$

$$(\text{Eq. 9})$$

$$\varphi(\omega) = \angle H(e^{j\omega}) = \text{atan}\left(\frac{-a_1 \cdot \sin\omega}{1 - a_1 \cos\omega}\right)$$

$$(\text{Eq. 10})$$

The primary current $i_p(t)$ through the conductor 8 (FIG. 1) is shown in Equation 11.

$$i_P(t) = A_P \cdot \sin(2\pi f_e t) = A_P \cdot \cos(2\pi f_e t + \varphi_P)$$

$$(\text{Eq. } 11)$$

In Equation 11, $A_p$ is the primary current's amplitude, E (in hertz) is the rated supply frequency, and the phase shift $\varphi_p$ = -$\pi$/2. For a power grid with a rated supply frequency of 60 Hz, $f_e$ = 60 Hz. Given the primary current $i_p(t)$ shown in Equation 11, the output voltage $v_R(t)$ of the Rogowski coil 2 is shown in Equation 12.

$$v_R(t) = M_R \cdot \frac{d}{dt} i_P(t) = 2\pi M_R A_P f_e \cos(2\pi f_e t)$$

$$(\text{Eq. } 12)$$

In Equation 12, $M_R = -\frac{\mu_0 N h_0}{2\pi} \cdot \ln\frac{r_2}{r_1}$ where $\mu_0$ is the permeability of the Rogowski coil 2, N is the number of turns of the Rogowski coil 2, $h_0$ is the height of the Rogowski coil 2, $r_2$ is an outer radius of the Rogowski coil 2, and $r_1$ is an inner radius of the Rogowski coil 2 (shown in FIG, 1).

Equation 13 shows the output voltage of the Rogowski coil 2 in the discrete-time domain.

$$v_R[n] = 2\pi M_R A_P f_e \cos(2\pi f_e \cdot nT_S) = 2\pi M_R A_P f_e \cos(\omega_e \cdot n)$$

$$(\text{Eq. } 13)$$

In Equation 13, $\omega_e = 2\pi\frac{f_e}{f_s}$ is the power grid's normalized angular frequency at rated condition. $f_s$ is the sampling frequency (in hertz) of the ADC 112. It is related to the sampling interval via $f_s$ = 1/Ts. The digital integrator 114 receives the Rogowski coil's 2 output voltage signal $v_R[n]$ as an input and computes a primary current signal y[n]. Given the digital integrator's 114 amplitude and phase responses shown in Equations 9 and 10, the primary current signal y[n] from the digital integrator 114 is shown in Equation 14.

$$y[n] = 2\pi M_R A_P f_e \cdot A(\omega_e) \cdot \cos[\omega_e \cdot n + \varphi(\omega_e)]$$

$$(\text{Eq. } 14)$$

In Equation 14, $A(\omega_c)$ and $\varphi(\omega_e)$ are the digital integrator's 114 amplitude and phase responses at $\omega_e$, respectively. If $\varphi(\omega_e)$ = -$\pi$/2, then the primary current signal y[n] is proportional to cos $\left(\omega_e n - \frac{\pi}{2}\right) = \cos(\omega_e n + \varphi_p)$. Equation 15 shows the phase difference (in radians) between $\varphi(\omega_e)$ and $\varphi_p$.

$$\Delta\varphi = \varphi(\omega_e) - \varphi_P = \varphi(\omega_e) + \frac{\pi}{2}$$

$$(\text{Eq. } 15)$$

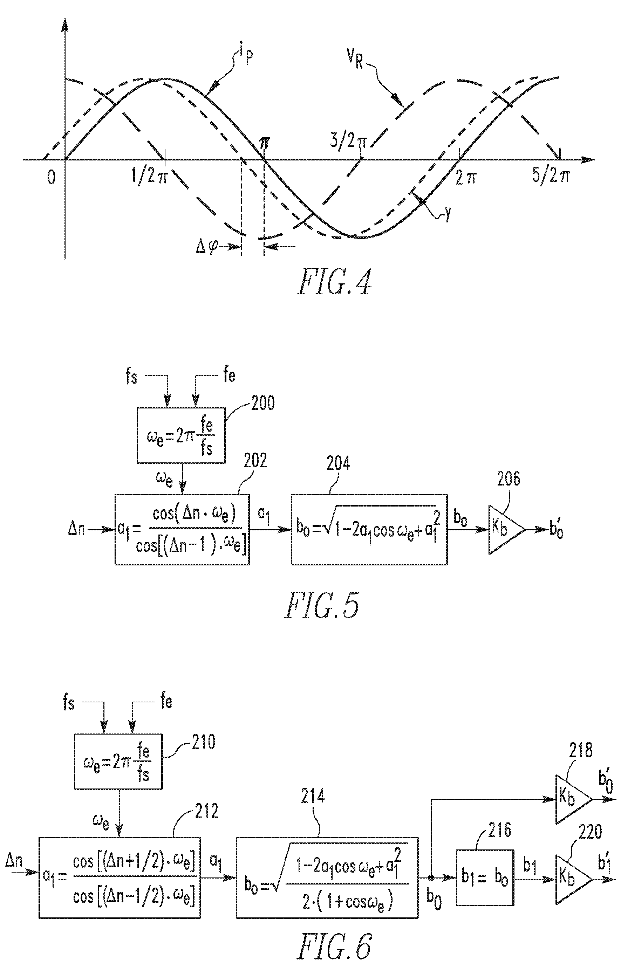

Note that the phase difference $\Delta\varphi$ corresponds to the phase lead between the primary current signal y[n] and the primary current $i_p(t)$ in the Rogowski coil 2. FIG. 4 illustrates waveforms of the Rogowski coil's 2 output voltage $v_R(t)$, the primary current $i_p(t)$, and the primary current signal y[n] and provides a visual illustration of the phase difference $\Delta\varphi$ between the primary current signal y[n] and the primary current $i_p(t)$.

The phase difference number of samples $\Delta n$ (i.e., the number of samples between the primary current signal y[n] and the primary current $i_p(t)$) may be determined using Equation 16.

$$\Delta n = \frac{\Delta t}{T_s} = \frac{\Delta\varphi/(2\pi f_e)}{T_s} = \frac{\Delta\varphi}{2\pi \frac{f_e}{f_s}} = \frac{\Delta\varphi}{\omega_e}$$

(Eq. 16)

Using Equations 10, 15, and 16 it is possible to determine a relation between $\Delta n$ and the coefficient $a_1$. The relation is shown in Equation 17.

$$a_1 = \frac{\cos(\Delta n \cdot \omega_e)}{\cos[(\Delta n - 1) \cdot \omega_e]}$$

(Eq. 17)

There are different ways to determine the coefficient $b_0$ once the coefficient $a_1$ has been determined. For example and without limitation, in some example embodiments of the disclosed concept, the digital integrator 114 has a unity gain at the power grid's normalized angular frequency at rated condition $\omega_e$. Using Equation 9 and setting the amplitude response $A(\omega_e)$ of the digital integrator 114 to one at the power grid's normalized angular frequency at rated condition $\omega_e$, it is possible to derive Equation 18 which shows the relation between the coefficients $a_1$ and $b_0$ when the digital integrator 114 has a unity gain at the power grid's normalized angular frequency at rated condition $\omega_e$.

$$b_0 = \sqrt{1 - 2a_1 \cos\omega_e + a_1^2}$$

(Eq. 18)

Using Equations 17 and 18, it is possible to input phase difference number of samples $\Delta n$, the sampling frequency $f_s$, and the rated supply frequency $f_e$ to determine the coefficients $a_1$ and $b_0$. For example and without limitation, in some example embodiments of the disclosed concept, the phase difference number of samples $\Delta n$ is 1, the sampling frequency $f_s$ is 4800 Hz, and the primary current frequency $f_e$ is 60 Hz. The corresponding coefficients $a_1$ and $b_0$ are 0.9969 and 0.07846, respectively.

Table 2 shows some values of the coefficients $a_1$ and $b_0$ when the sampling frequency $f_s$ is 4800 Hz and the primary current frequency $f_e$ is 60 Hz.

TABLE 2

| $\Delta n$ | $a_1$ | $b_0$ |
|---|---|---|
| 1 | 0.9969 | 0.07846 |
| 2 | 0.9907 | 0.07870 |
| 3 | 0.9845 | 0.07944 |
| 4 | 0.9781 | 0.08069 |

FIG. 5 is a flowchart for computing the coefficients $a_1$ and $b_0$ based on the sampling frequency $f_s$ the rated supply frequency $f_e$, and the phase difference number of samples $\Delta n$ when the digital integrator 114 uses a discrete-time transfer function that is an impulse-invariant transformation of the transfer function of an analog integrator. In some example embodiments of the disclosed concept, the coefficient $b_0$ may be scaled by a non-zero factor $k_b$ to a coefficient $b'_0$.

First, the sampling frequency $f_s$, the rated supply frequency $f_e$, and the phase difference number of samples

9

An are provided. The power grid's normalized angular frequency at rated condition $\omega_e$, is obtained using $\omega_e = 2\pi \frac{f_e}{f_s}$ at 200. The first coefficient $a_1$ is obtained using equation 17 at 202, and the second coefficient $b_0$ is obtained using equation 18 at 204. In some example embodiments of the disclosed concept, the second coefficient $b_0$ may be scaled at 206 to obtain a scaled second coefficient $b'_0$.

In some example embodiments of the disclosed concept, the sampling frequency $f_s$ is chosen as a predetermined multiple of the rated supply frequency $f_e$. In this case, the coefficients $a_1$ and $b_0$ will remain the same even if the rated supply frequency $f_e$ is changed.

Equations 8-18 are related to determining the coefficients $a_1$ and $b_0$ of the digital integrator 114 when the digital integrator 144 implements a discrete-time transfer function that is an impulse-invariant transformation of the transfer function of an analog integrator. In some example embodiments of the disclosed concept, the digital integrator 114 implements a discrete time transfer function that is a bilinear transformation of the transfer function of an analog integrator. In this case, the following equations may be used to determine the coefficients $a_1$, $b_0$, and $b_1$. In some example embodiments of the disclosed concept, the coefficients $b_0$ and $b_1$ are equal.

The discrete-time transfer function H(z) in Equation 7 is the bilinear transformation of the transfer function of an analog integrator. The frequency response of the discrete-time transfer function of Equation 7 is shown in Equation 19.

$$H\left(e^{j\omega}\right) = \frac{b_0\left(1 + e^{-j\omega}\right)}{1 - a_1 e^{-j\omega}}$$

$$= \frac{b_0}{1 - 2a_1 \cos\omega + a_1^2} \cdot \left[(1 - a_1) \cdot (1 + \cos\omega) - j \cdot (1 + a_1) \cdot \sin\omega\right]$$

$$\text{(Eq. 19)}$$

From Equation 19, it is possible to determine the amplitude response and phase response, which are respectively shown in Equations 20 and 21.

$$A(\omega) = \left|H\left(e^{j\omega}\right)\right| = b_0 \cdot \sqrt{\frac{2 \cdot (1 + \cos\omega)}{1 - 2a_1 \cos\omega + a_1^2}}$$

$$\text{(Eq. 20)}$$

$$\varphi(\omega) = \angle H\left(e^{j\omega}\right) = \operatorname{atan}\left[\frac{-(1 + a_1) \cdot \sin\omega}{(1 - a_1) \cdot (1 + \cos\omega)}\right]$$

$$\text{(Eq. 21)}$$

The phase difference $\Delta\varphi$ and the phase difference number of samples $\Delta n$ are provided by Equations 15 and 16, respectively. Using Equations 15, 16, and 21, it is possible to determine the relation between the phase difference number of samples $\Delta n$ and the coefficient $a_1$, as is shown in Equation 22.

$$a_1 = \frac{\cos\left[\left(\Delta n + \frac{1}{2}\right) \cdot \omega_e\right]}{\cos\left[\left(\Delta n - \frac{1}{2}\right) \cdot \omega_e\right]}$$

$$\text{(Eq. 22)}$$

Assuming that the digital integrator 114 has a unity gain at $\omega_e$, the coefficient $b_0$ is provided by Equation 23.

$$b_0 = b_1 = \sqrt{\frac{1 - 2a_1 \cos \omega_e + a_1^2}{2 \cdot (1 + \cos \omega_e)}}$$

(Eq. 23)

Table 3 shows some values for coefficients $a_1$, $b_0$, and $b_1$ when the rated supply frequency $f_e$ is 50 Hz and the sampling frequency $f_s$ is 4000 Hz (e.g., the sampling frequency $f_s$ is 80 times the rated supply frequency $f_e$.

TABLE 3

| $\Delta n$ | $a_1$ | $b_0$ | $b_1$ |
|---|---|---|---|
| 1 | 0.9938 | 0.03929 | 0.03929 |
| 2 | 0.9876 | 0.03953 | 0.03953 |
| 3 | 0.9813 | 0.04003 | 0.04003 |
| 4 | 0.9748 | 0.04079 | 0.04079 |

FIG. 6 is a flowchart for computing the coefficients $a_1$, $b_0$, and $b_1$ based on the sampling frequency $f_s$, the rated supply frequency $f_e$, and the phase difference number of samples An when the digital integrator 114 uses a discrete-time transfer function that is a bilinear transformation of the transfer function of an analog integrator. In some example embodiments of the disclosed concept, the coefficients $b_0$ and $b_1$ may be scaled by a non-zero factor $k_b$ to coefficients $b'_0$ and $b'_1$.

First, the sampling frequency $f_s$, the rated supply frequency $f_e$, and the phase difference number of samples

$$\omega_e = 2\pi \frac{f_e}{f_s}$$

An are provided. The power grid's normalized angular frequency at rated condition $\omega_e$, is obtained using at 210. The first coefficient $a_1$ is obtained using equation 22 at 212. The second coefficient $b_0$ and the third coefficient $b_1$ are obtained using equation 23 at 214 and 216. In some example embodiments of the disclosed concept, the second coefficient $b_0$ and third coefficient $b_1$ may be scaled at 218 and 220 to obtain a scaled second coefficient $b'_0$ and a scaled third coefficient $b'_1$.

In accordance with example embodiments of the disclosed concept, the phase delay (e.g., the phase difference number of sample $\Delta n$) of the digital integrator 114 may be precisely designed and tuned. The design and tuning affords more precise control of the phase delay than analog integrators such as the one used in the current sensing circuitry shown in FIG. 2. The ability to tune the digital integrator's 114 phase delay significantly simplifies metering calibration tasks and helps meet performance constraints in protection, metering, and monitoring applications.

Referring back to FIG. 3, current sensing circuitry 100 further includes a DC blocker filter 1 16. The DC blocker filter 116 is structured to receive the output of the digital integrator 114. The DC blocker filter 116 is structured to filter the output of the digital integrator to remove a DC bias from the output of the digital integrator 114. The DC blocker filter 116 produces a digital current output signal $i_Q[n]$. The digital current output signal $i_Q[n]$ is proportional to the primary current $i_p(t)$.

In some example embodiments of the disclosed concept, the DC blocker filter 116 implements the transfer function shown in Equation 24.

$$H(z) = \frac{y(z)}{x(z)} = \frac{b_0 + b_1 z^{-1}}{1 - a_1 z^{-1}}$$

(Eq. 24)

In Equation 24, $0 < a_1 < 1$, $b_0$, = 1, and $b_1$ = -1. In some example embodiments of the disclosed concept, the value of $a_1$ is chosen to be close to 1 to provide reasonably good DC blocking performance.

11

In some example embodiments of the disclosed concept, the digital integrator 114 and the DC blocker filter 116 may be implemented as digital biquadratic filters, also referred to as a digital biquad filter. In some example embodiments of the disclosed concept, the digital biquad filter has the transfer function shown in Equation 25.

$$H(z) = \frac{y(z)}{x(z)} = \frac{b_0 + b_1 z^{-1} + b_2 z^{-2}}{1 - a_1 z^{-1} - a_2 z^{-2}}$$

$$(Eq. 25)$$

Table 4 shows the selection of coefficients $a_1$, $a_2$, $b_0$, $b_1$, and $b_2$ based on the type of component that is implemented in the digital biquad filter.

TABLE 4

| Type | | $a_1$ | $a_2$ | $b_0$ | $b_1$ | $b_2$ |
|---|---|---|---|---|---|---|
| Digital Integrator | Impulse-invariant transform | $\neq 0$ | $= 0$ | $\neq 0$ | $= 0$ | $= 0$ |
| | Bilinear transform | $\neq 0$ | $= 0$ | $\neq 0$ | $= b_0$ | $= 0$ |
| DC blocker filter | | $\neq 0$ | $= 0$ | $= 1$ | $= -1$ | $= 0$ |

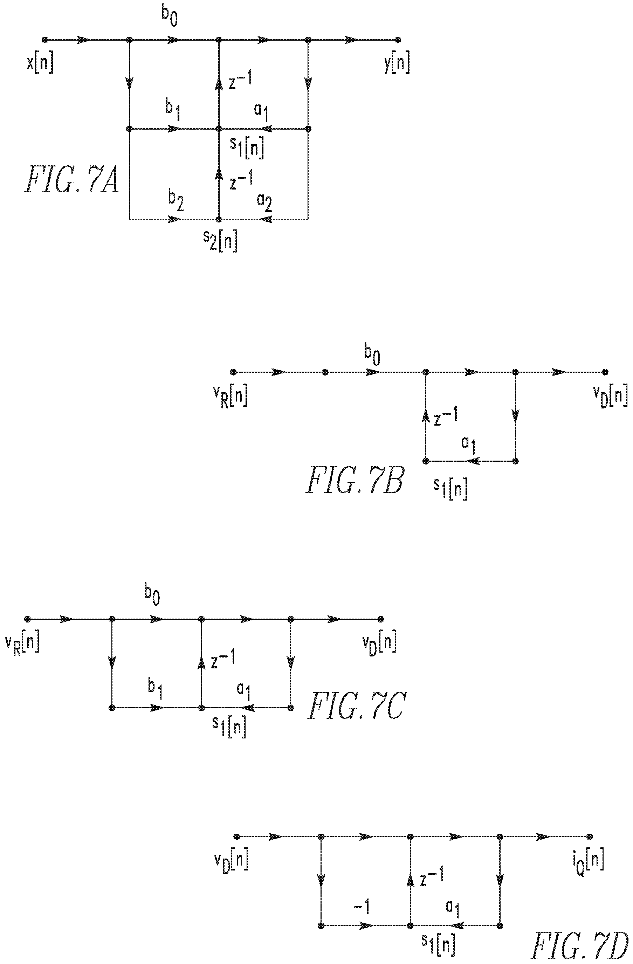

FIG. 7a is a signal flow graph of a digital biquad filter in the discrete-time domain. In FIG. 7a, x[n] is the input to the digital biquad filter and y[n] is the output of the digital biquad filter. Applying the coefficient values in Table 4 to the signal flow graph of FIG. 7a produces signal flow graphs corresponding to the different types of filters that maybe implemented in the digital biquad filter. FIG. 7b is a signal flow graph of a digital integrator using the impulse-invariant transform. FIG. 7c is a signal flow graph of a digital integrator using a bilinear transform, and FIG. 7d is a signal flow graph of a DC blocker filter.

In some example embodiments of the disclosed concept, the digital integrator output signal $v_D[n]$ of the digital integrator 114 may be used for the purpose of circuit protection and the digital current output signal $i_Q[n]$ is proportional to the primary current $i_P(t)$ and may be used for metering or control purposes. However, it will be appreciated by those having ordinary skill in the art that the outputs $v_D[n]$ and $i_Q[n]$ may be used for any purpose without departing from the scope of the disclosed concept.

The ADC 112 may be implemented using any suitable electronic components such as, for example and without limitation, an integrated circuit and/or other circuit components. The digital integrator 114 and the DC blocker filter 116 may be implemented using any suitable electronic components such as, for example and without limitation, microchips, other circuit components, and/or electronic components used in digital filtering applications. One or more of the ADC 112, the digital integrator 114, and the DC blocker filter 116 may be implemented using any suitable components. For example and without limitation, one or more of the ADC 112, the digital integrator 114, and the DC blocker filter 116 may be implemented in a processor. The processor may have an associated memory. The processor may be, for example and without limitation, a microprocessor, a microcontroller, or some other suitable processing device or circuitry, that interfaces with the memory or another suitable memory. The memory may be any of one or more of a variety of types of internal and/or external storage media such as, without limitation, RAM, ROM, EPROM(s), EEPROM(s), FLASH, and the like that provide a storage register, i.e., a machine readable medium, for data storage such as in the fashion of an internal storage area of a computer, and can be volatile memory of nonvolatile memory. The memory may store one or more routines which, when executed by the processor, cause the processor to implement at least some of its functionality.

While specific embodiments of the disclosed concept have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of the disclosed concept which is to be given the full breadth of the claims appended.

**Claims**

1. A current sensing circuit (100) for use with a Rogowski coil (2) arranged around a conductor (8) having a primary current, the current sensing circuit (100) comprising:

input terminals (102,104) structured to receive an output voltage of the Rogowski coil (2);
filtering elements (106,108) structured to filter high frequency voltage from the output voltage and to output a filtered output voltage;
an amplifier (110) structured to receive the filtered output voltage and produce a differential voltage;
an analog to digital converter (112) structured to convert the differential voltage to a digital differential voltage signal;
a digital integrator (114) structured to receive the digital differential voltage signal, to implement a discrete-time transfer function that is a transform of a transfer function of an analog integrator, and to output a digital integrator output signal;
a direct current blocker filter (116) structured to remove a direct current bias from the digital integrator output signal and to output a digital current output signal that is proportional to the primary current in the conductor (8), wherein the discrete-time transform implemented by the digital integrator (114) is an impulse-invariant transform of the transfer function of the analog integrator,
wherein the analog integrator is an RC-filter having a resistance of R and a capacitance of C; and wherein the discrete-time transfer function of the digital integrator (114) is defined by the following equation:

$$H(z) = \frac{y(z)}{x(z)} = \frac{\alpha \cdot T_S}{1 - e^{-\alpha T_S}z^{-1}} = \frac{b_0}{1 - a_1 z^{-1}}$$

where $T_s$ is a sampling interval; $\alpha = \frac{1}{RC}; a_1 = e^{-\alpha T_s} = e^{-\frac{T_s}{RC}}$ ; $b_0 = \alpha \cdot T_s$; and $z^{-1}$ denotes a one-sample delay,
wherein the digital integrator (114) has coefficients of $a_1$ and $b_0$; wherein $a_1$ is defined by the following equation:

$$a_1 = \frac{\cos(\Delta n \cdot \omega_e)}{\cos[(\Delta n - 1) \cdot \omega_e]}$$

wherein $b_0$ is defined by the following equation:

$$b_0 = \sqrt{1 - 2a_1 \cos \omega_e + a_1^2}$$

wherein $\Delta n$ is the number of samples between the digital current output signal and the primary current in the conductor (8); $\omega_e = 2\pi \frac{f_e}{f_s}$ , $f_e$ is a rated supply frequency, and $f_s$ is a sampling frequency of the analog to digital converter (112),
wherein the rated supply frequency is related to the primary current by the following equation:

$$i_p(t) = A_p \cdot \sin(2\pi f_e t)$$

where $i_p(t)$ is the primary current, and where $A_p$ is an amplitude of the primary current $i_p(t)$.

2. A current sensing circuit (100) for use with a Rogowski coil (2) arranged around a conductor (8) having a primary current, the current sensing circuit (100) comprising:

input terminals (102,104) structured to receive an output voltage of the Rogowski coil (2);
filtering elements (106,108) structured to filter high frequency voltage from the output voltage and to output a filtered output voltage;
an amplifier (110) structured to receive the filtered output voltage and produce a differential voltage;
an analog to digital converter (112) structured to convert the differential voltage to a digital differential voltage signal;
a digital integrator (114) structured to receive the digital differential voltage signal, to implement a discrete-time transfer function that is a transform of a transfer function of an analog integrator, and to output a digital integrator output signal;

a direct current blocker filter (116) structured to remove a direct current bias from the digital integrator output signal and to output a digital current output signal that is proportional to the primary current in the conductor (8), wherein the discrete-time transform implemented by the digital integrator (114) is a bilinear transform of the transfer function of the analog integrator,

wherein the analog integrator is an RC-filter having a resistance of R and a capacitance of C; and wherein the discrete-time transfer function of the digital integrator (114) is defined by the following equation:

$$H(z) = \frac{y(z)}{x(z)} = \frac{\frac{\alpha T_S}{2+\alpha T_S} + \frac{\alpha T_S}{2+\alpha T_S}z^{-1}}{1 - \frac{2-\alpha T_S}{2+\alpha T_S}z^{-1}} = \frac{b_0 + b_1 z^{-1}}{1 - a_1 z^{-1}}$$

$$\alpha = \frac{1}{RC}; a_1 = \frac{2-\alpha T_s}{2+\alpha T_s}, b_0 = b_1 = \frac{\alpha T_s}{2+\alpha T_s}$$

where $T_s$ is a sampling interval; , and $z^{-1}$ denotes a one-sample delay,

wherein the digital integrator (114) has coefficients of $a_1$, $b_0$, and $b_1$;

wherein $a_1$ is defined by the following equation:

$$a_1 = \frac{\cos\left[\left(\Delta n + \frac{1}{2}\right) \cdot \omega_e\right]}{\cos\left[\left(\Delta n - \frac{1}{2}\right) \cdot \omega_e\right]}$$

and wherein b0 and b1 are defined by the following equation:

$$b_0 = b_1 = \sqrt{\frac{1 - 2a_1 \cos \omega_e + a_1^2}{2 \cdot (1 + \cos \omega_e)}}$$

wherein $\Delta n$ is the number of samples between the digital current output signal and the primary current in the conductor (8);

$$\omega_e = 2\pi \frac{f_e}{f_s}, f_e$$

is a rated supply frequency, and $f_s$ is a sampling frequency of the analog to digital converter (112),

wherein the rated supply frequency is related to the primary current by the following equation:

$$i_p(t) = A_p \cdot \sin(2\pi f_e t)$$

where $i_p(t)$ is the primary current, and where $A_p$ is an amplitude of the primary current $i_p(t)$.

3. The current sensing circuit (100) of claim 1, wherein the direct current blocker filter (116) has a transfer function defined by the following equation:

$$H(z) = \frac{y(z)}{x(z)} = \frac{b_0 + b_1 z^{-1}}{1 - a_1 z^{-1}}$$

where $0 < a_1 < 1$, $b_0 = 1$, and $b_1 = -1$.

4. The current sensing circuit (100) of claim 1, wherein the direct current blocker filter (116) is implemented with a digital biquadratic filter having a transfer function defined by the following equation:

$$H(z) = \frac{y(z)}{x(z)} = \frac{b_0 + b_1 z^{-1} + b_2 z^{-2}}{1 - a_1 z^{-1} - a_2 z^{-2}}$$

where $z^{-1}$ denotes a one sample delay, $z^{-2}$ denotes a two sample delay, and $a_1$, $a_2$, $b_0$, $b_1$, and $b_2$ are coefficients.

5. The current sensing circuit (100) of claim 4, wherein the direct current blocker filter (116) is implemented with the digital biquadratic filter; and wherein $a_1 \neq 0$, $a_2 = 0$, $b_0 = 1$, $b_1 = -1$, and $b_2 = 0$.

6. The current sensing circuit (100) of claim 1, wherein the filtering elements (106, 108) include at least one ferrite bead.

7. A method of implementing a digital integrator (114), the method comprising:

providing a sampling frequency $f_s$;
providing a rated supply frequency $f_e$;
providing a number $\Delta n$ of samples between a digital current output signal proportional to a primary current in a conductor (8) and the primary current in the conductor (8);
obtaining a power grid's normalized angular frequency at rated condition using the following equation:

$$\omega_e = 2\pi \frac{f_e}{f_s}$$

obtaining a first coefficient $a_1$ based on the following equation:

$$a_1 = \frac{\cos(\Delta n \cdot \omega_e)}{\cos[(\Delta n - 1) \cdot \omega_e]}$$

obtaining a second coefficient based on the following equation:

$$b_0 = \sqrt{1 - 2a_1 \cos \omega_e + a_1^2}$$

implementing the digital integrator (114) as a digital filter by implementing a discrete-time transfer function using the first coefficient $a_1$ and the second coefficient $b_0$,
wherein the discrete-time transfer function is an impulse-invariant transform of a transfer function of an analog integrator,
wherein the analog integrator is an RC-filter having a resistance of R and a capacitance of C,
wherein the discrete-time transfer function is defined by the following equation:

$$H(z) = \frac{y(z)}{x(z)} = \frac{\alpha \cdot T_s}{1 - e^{-\alpha T_s} z^{-1}} = \frac{b_0}{1 - a_1 z^{-1}}$$

where $T_s$ is a sampling interval; $\alpha = \frac{1}{RC}$; $a_1 = e^{-\alpha T_s} = e^{-\frac{T_s}{RC}}$; $b_0 = \alpha \cdot T_s$; and $z^{-1}$ denotes a one-sample delay,
wherein the rated supply frequency is related to the primary current in the conductor (8) by the following equation:

$$i_p(t) = A_p \cdot \sin(2\pi f_e t)$$

where $i_p(t)$ is the primary current in the conductor (8), and where $A_p$ is an amplitude of the primary current in the conductor $i_p(t)$.

**8.** A method of implementing a digital integrator (114), the method comprising:

providing a sampling frequency $f_s$;
providing a rated supply frequency $f_e$;
providing a number $\Delta n$ of samples between a digital current output signal proportional to a primary current in a conductor (8) and the primary current in the conductor (8);
obtaining a power grid's normalized angular frequency at rated condition using the following equation:

$$\omega_e = 2\pi \frac{f_e}{f_s}$$

obtaining a first coefficient $a_1$ based on the following equation:
obtaining a second coefficient $b_0$ and a third coefficient $b_1$ based on the following equation:

$$b_0 = b_1 = \sqrt{\frac{1 - 2a_1 \cos \omega_e + a_1^2}{2 \cdot (1 + \cos \omega_e)}}$$

implementing the digital integrator (114) as a digital filter by implementing a discrete-time transfer function using the first coefficient $a_1$, the second coefficient $b_0$, and the third coefficient $b_1$,
wherein the discrete-time transfer function is a bilinear transform of a transfer function of an analog integrator,
wherein the analog integrator is an RC-filter having a resistance of R and a capacitance of C,
wherein the discrete-time transfer function of the digital integrator (114) is defined by the following equation:

$$H(z) = \frac{y(z)}{x(z)} = \frac{\frac{\alpha T_s}{2+\alpha T_s} + \frac{\alpha T_s}{2+\alpha T_s}z^{-1}}{1 - \frac{2-\alpha T_s}{2+\alpha T_s}z^{-1}} = \frac{b_0 + b_1 z^{-1}}{1 - a_1 z^{-1}}$$

$$\alpha = \frac{1}{RC}; \; a_1 = \frac{2-\alpha T_s}{2+\alpha T_s}, \; b_0 = b_1 = \frac{\alpha T_s}{2+\alpha T_s}$$

where Ts is a sampling interval; , and $z^{-1}$ denotes a one-sample delay,
wherein the rated supply frequency is related to the primary current in the conductor (8) by the following equation:

$$i_p(t) = A_p \cdot \sin(2\pi f_e t)$$

where $i_p(t)$ is the primary current in the conductor (8), and where $A_p$ is an amplitude of the primary current $i_p(t)$.

**Patentansprüche**

**1.** Strommessschaltung (100) zur Verwendung mit einer Rogowski-Spule (2), die um einen Leiter (8) mit einem Primärstrom angeordnet ist, wobei die Strommessschaltung (100) umfasst:

Eingangsanschlüsse (102,104), die strukturiert sind, um eine Ausgangsspannung der Rogowski-Spule (2) zu empfangen;
Filterelemente (106,108), die strukturiert sind, um Hochfrequenzspannung von der Ausgangsspannung zu filtern und eine gefilterte Ausgangsspannung auszugeben;
einen Verstärker (110), der strukturiert ist, um die gefilterte Ausgangsspannung zu empfangen und eine Differenzspannung zu erzeugen;
einen Analog-Digital-Wandler (112), der strukturiert ist, um die Differenzspannung in ein digitales Differenzspannungssignal umzuwandeln;
einen digitalen Integrator (114), der strukturiert ist, um das digitale Differenzspannungssignal zu empfangen, um eine zeitdiskrete Übertragungsfunktion zu implementieren, die eine Transformation einer Übertragungsfunktion eines analogen Integrators ist, und um ein digitales Integratorausgangssignal auszugeben;

einen DC-Blocker-Filter (116), der strukturiert ist, um eine Gleichstromvorspannung aus dem digitalen Integratorausgangssignal zu entfernen und ein digitales Stromausgangssignal auszugeben, das proportional zu dem Primärstrom in dem Leiter (8) ist,

wobei die durch den digitalen Integrator (114) implementierte zeitdiskrete Transformation eine Impulsinvarianz-Transformation der Übertragungsfunktion des analogen Integrators ist,

wobei der analoge Integrator ein RC-Filter mit einem Widerstand von R und einer elektrischen Kapazität von C ist; und wobei die zeitdiskrete Übertragungsfunktion des digitalen Integrators (114) durch die folgende Gleichung definiert ist:

$$H(z) = \frac{y(z)}{x(z)} = \frac{\alpha \cdot T_S}{1 - e^{-\alpha T_S} z^{-1}} = \frac{b_0}{1 - a_1 z^{-1}}$$

wobei $T_s$ ein Abtastintervall ist; $\alpha = \frac{1}{RC}$ ; $a_1 = e^{-\alpha T_s} = e^{-\frac{T_s}{RC}}$ ; $b_0 = \alpha \cdot T_s$; und $z^{-1}$ eine One-Sample-Verzögerung bezeichnet,

wobei der digitale Integrator (114) Koeffizienten von $a_1$ und $b_0$ aufweist; wobei $a_1$ durch die folgende Gleichung definiert ist:

$$a_1 = \frac{\cos(\Delta n \cdot \omega_e)}{\cos[(\Delta n - 1) \cdot \omega_e]}$$

wobei $b_0$ durch die folgende Gleichung definiert ist:

$$b_0 = \sqrt{1 - 2a_1 \cos \omega_e + a_1^2}$$

wobei $\Delta n$ die Anzahl von Samples zwischen dem digitalen Stromausgangssignal und dem Primärstrom in dem Leiter (8) ist; $\omega_e = 2\pi \frac{f_e}{f_s}$ , $f_e$ eine Nennversorgungsfrequenz und $f_s$ eine Abtastfrequenz des Analog-Digital-Wandlers (112) ist,

wobei die Nennversorgungsfrequenz mit dem Primärstrom durch die folgende Gleichung in Beziehung steht:

$$i_p(t) = A_p \cdot \sin(2\pi f_e t)$$

wobei $i_p(t)$ der Primärstrom ist, und wobei $A_p$ eine Amplitude des Primärstroms $i_p(t)$ ist.

2. Strommessschaltung (100) zur Verwendung mit einer Rogowski-Spule (2), die um einen Leiter (8) mit einem Primärstrom angeordnet ist, wobei die Strommessschaltung (100) umfasst:

Eingangsanschlüsse (102,104), die strukturiert sind, um eine Ausgangsspannung der Rogowski-Spule (2) zu empfangen;
Filterelemente (106,108), die strukturiert sind, um Hochfrequenzspannung von der Ausgangsspannung zu filtern und eine gefilterte Ausgangsspannung auszugeben;
einen Verstärker (110), der strukturiert ist, um die gefilterte Ausgangsspannung zu empfangen und eine Differenzspannung zu erzeugen;
einen Analog-Digital-Wandler (112), der strukturiert ist, um die Differenzspannung in ein digitales Differenzspannungssignal umzuwandeln;
einen digitalen Integrator (114), der strukturiert ist, um das digitale Differenzspannungssignal zu empfangen, um eine zeitdiskrete Übertragungsfunktion zu implementieren, die eine Transformation einer Übertragungsfunktion eines analogen Integrators ist, und um ein digitales Integratorausgangssignal auszugeben;
einen DC-Blocker-Filter (116), der strukturiert ist, um eine Gleichstromvorspannung aus dem digitalen Integratorausgangssignal zu entfernen und ein digitales Stromausgangssignal auszugeben, das proportional zu dem Primärstrom in dem Leiter (8) ist,

wobei die durch den digitalen Integrator (114) implementierte zeitdiskrete Transformation eine bilineare Transformation der Übertragungsfunktion des analogen Integrators ist,

wobei der analoge Integrator ein RC-Filter mit einem Widerstand von R und einer elektrischen Kapazität von C ist; und wobei die zeitdiskrete Übertragungsfunktion des digitalen Integrators (114) durch die folgende Gleichung definiert ist:

$$H(z) = \frac{y(z)}{x(z)} = \frac{\frac{\alpha T_S}{2+\alpha T_S} + \frac{\alpha T_S}{2+\alpha T_S} z^{-1}}{1 - \frac{2-\alpha T_S}{2+\alpha T_S} z^{-1}} = \frac{b_0 + b_1 z^{-1}}{1 - a_1 z^{-1}}$$

wobei $T_s$ ein Abtastintervall ist; und $\alpha = \frac{1}{RC}$; $a_1 = \frac{2-\alpha T_s}{2+\alpha T_s}$, $b_0 = b_1 = \frac{\alpha T_s}{2+\alpha T_s}$, und $z^{-1}$ eine One-Sample-Verzögerung bezeichnet,

wobei der digitale Integrator (114) Koeffizienten von $a_1$, $b_0$ und $b_1$ aufweist; wobei $a_1$ durch die folgende Gleichung definiert ist:

$$a_1 = \frac{\cos\left[\left(\Delta n + \frac{1}{2}\right) \cdot \omega_e\right]}{\cos\left[\left(\Delta n - \frac{1}{2}\right) \cdot \omega_e\right]}$$

und wobei $b_0$ und $b_1$ durch die folgende Gleichung definiert sind:

$$b_0 = b_1 = \sqrt{\frac{1 - 2a_1 \cos \omega_e + a_1^2}{2 \cdot (1 + \cos \omega_e)}}$$

wobei $\Delta n$ die Anzahl von Samples zwischen dem digitalen Stromausgangssignal und dem Primärstrom in dem Leiter (8) ist;

$\omega_e = 2\pi \frac{f_e}{f_s}$, $f_e$ is aeine Nennversorgungsfrequenz ist und $f_s$ eine Abtastfrequenz des Analog-Digital-Wandlers (112) ist,

wobei die Nennversorgungsfrequenz mit dem Primärstrom durch die folgende Gleichung in Beziehung steht:

$$i_p(t) = A_p \cdot \sin(2\pi f_e t)$$

wobei $i_p(t)$ der Primärstrom ist, und wobei $A_p$ eine Amplitude des Primärstroms $i_p(t)$ ist.

3. Strommessschaltung (100) nach Anspruch 1, wobei der DC-Blocker-Filter (116) eine Übertragungsfunktion aufweist, die durch die folgende Gleichung definiert ist:

$$H(z) = \frac{y(z)}{x(z)} = \frac{b_0 + b_1 z^{-1}}{1 - a_1 z^{-1}}$$

wobei $0 < a_1 < 1$, $b_0 = 1$ und $b_1 = -1$ ist.

4. Strommessschaltung (100) nach Anspruch 1, wobei der DC-Blocker-Filter (116) mit einem digitalen biquadratischen Filter implementiert ist, der eine Übertragungsfunktion aufweist, die durch die folgende Gleichung definiert ist:

$$H(z) = \frac{y(z)}{x(z)} = \frac{b_0 + b_1 z^{-1} + b_2 z^{-2}}{1 - a_1 z^{-1} - a_2 z^{-2}}$$

wobei $z^{-1}$ eine One-Sample-Verzögerung bezeichnet, $z^{-2}$ eine Two-Sample-Verzögerung bezeichnet und $a_1$, $a_2$, $b_0$, $b_1$ und $b_2$ Koeffizienten sind.

5. Strommessschaltung (100) nach Anspruch 4, wobei der DC-Blocker-Filter (116) mit dem digitalen biquadratischen Filter implementiert ist; und wobei $a_1 \neq 0$, $a_2 = 0$, $b_0 = 1$, $b_1 = -1$ und $b_2 = 0$ ist.

6. Strommessschaltung (100) nach Anspruch 1, wobei die Filterelemente (106, 108) mindestens ein Ferritkügelchen einschließen.

7. Verfahren zum Implementieren eines digitalen Integrators (114), wobei das Verfahren umfasst:

Bereitstellen einer Abtastfrequenz $f_s$;
Bereitstellen einer Nennversorgungsfrequenz $f_e$;
Bereitstellen einer Anzahl $\Delta n$ von Abtastwerten zwischen einem digitalen Stromausgangssignal, das zu einem Primärstrom in einem Leiter (8) proportional ist, und dem Primärstrom in dem Leiter (8);
Erhalten einer normalisierten Winkelfrequenz des Stromnetzes im Nennzustand unter Verwendung der folgenden Gleichung:

$$\omega_e = 2\pi \frac{f_e}{f_s}$$

Erhalten eines ersten Koeffizienten $a_1$ basierend auf der folgenden Gleichung:

$$a_1 = \frac{\cos(\Delta n \cdot \omega_e)}{\cos[(\Delta n - 1) \cdot \omega_e]}$$

Erhalten eines zweiten Koeffizienten basierend auf der folgenden Gleichung:

$$b_0 = \sqrt{1 - 2a_1 \cos \omega_e + a_1^2}$$

Implementieren des digitalen Integrators (114) als digitalen Filter durch Implementieren einer zeitdiskreten Übertragungsfunktion unter Verwendung des ersten Koeffizienten $a_1$ und des zweiten Koeffizienten $b_0$,
wobei die zeitdiskrete Übertragungsfunktion eine Impulsinvarianz-Transformation einer Übertragungsfunktion eines analogen Integrators ist,
wobei der analoge Integrator ein RC-Filter mit einem Widerstand von R und einer elektrischen Kapazität von C ist,
wobei die zeitdiskrete Übertragungsfunktion durch die folgende Gleichung definiert ist:

$$H(z) = \frac{y(z)}{x(z)} = \frac{\alpha \cdot T_S}{1 - e^{-\alpha T_S} z^{-1}} = \frac{b_0}{1 - a_1 z^{-1}}$$

$$\alpha = \frac{1}{RC}; a_1 = e^{-\alpha T_s} = e^{-\frac{T_s}{RC}}$$

wobei $T_s$ ein Abtastintervall ist; $\ ; b_0 = \alpha \cdot T_s$; und $z^{-1}$ eine One-Sample-Verzögerung bezeichnet,
wobei die Nennversorgungsfrequenz mit dem Primärstrom durch die folgende Gleichung in dem Leiter (8) in Beziehung steht:

$$i_p(t) = A_p \cdot \sin(2\pi f_e t)$$

wobei $i_p(t)$ der Primärstrom in dem Leiter (8) ist, und wobei $A_p$ eine Amplitude des Primärstroms im Leiter $i_p(t)$ ist.

8. Verfahren zum Implementieren eines digitalen Integrators (114), wobei das Verfahren umfasst:

Bereitstellen einer Abtastfrequenz $f_s$;

Bereitstellen einer Nennversorgungsfrequenz $f_e$;

Bereitstellen einer Anzahl $\Delta n$ von Abtastwerten zwischen einem digitalen Stromausgangssignal, das zu einem Primärstrom in einem Leiter (8) proportional ist, und dem Primärstrom in dem Leiter (8);

Erhalten einer normalisierten Winkelfrequenz des Stromnetzes im Nennzustand unter Verwendung der folgenden Gleichung:

$$\omega_e = 2\pi \frac{f_e}{f_s}$$

Erhalten eines ersten Koeffizienten $a_1$ basierend auf der folgenden Gleichung:

Erhalten eines zweiten Koeffizienten $b_0$ und eines dritten Koeffizienten $b_1$ basierend auf der folgenden Gleichung ist:

$$b_0 = b_1 = \sqrt{\frac{1 - 2a_1 \cos \omega_e + a_1^2}{2 \cdot (1 + \cos \omega_e)}}$$

Implementieren des digitalen Integrators (114) als einen digitalen Filter durch Implementieren einer zeitdiskreten Übertragungsfunktion unter Verwendung des ersten Koeffizienten $a_1$, des zweiten Koeffizienten $b_0$ und des dritten Koeffizienten $b_1$,

wobei die zeitdiskrete Übertragungsfunktion eine bilineare Transformation einer Übertragungsfunktion eines analogen Integrators ist,

wobei der analoge Integrator ein RC-Filter mit einem Widerstand von R und einer elektrischen Kapazität von C ist,

wobei die zeitdiskrete Übertragungsfunktion des digitalen Integrators (114) durch die folgende Gleichung definiert ist:

$$H(z) = \frac{y(z)}{x(z)} = \frac{\frac{\alpha T_s}{2 + \alpha T_s} + \frac{\alpha T_s}{2 + \alpha T_s} z^{-1}}{1 - \frac{2 - \alpha T_s}{2 + \alpha T_s} z^{-1}} = \frac{b_0 + b_1 z^{-1}}{1 - a_1 z^{-1}}$$

$$\alpha = \frac{1}{RC}; \ a_1 = \frac{2 - \alpha T_s}{2 + \alpha T_s}, \ b_0 = b_1 = \frac{\alpha T_s}{2 + \alpha T_s}$$

wobei $T_s$ ein Abtastintervall ist; , und $z^{-1}$ eine One-Sample-Verzögerung bezeichnet,

wobei die Nennversorgungsfrequenz mit dem Primärstrom durch die folgende Gleichung in dem Leiter (8) in Beziehung steht:

$$i_p(t) = A_p \cdot \sin(2\pi f_e t)$$

wobei $i_p(t)$ der Primärstrom in dem Leiter (8) ist, und wobei $A_p$ eine Amplitude des Primärstroms $i_p(t)$ ist.

## Revendications

1. Circuit de détection de courant (100) destiné à être utilisé avec un enroulement de Rogowski (2) agencé autour d'un conducteur (8) ayant un courant primaire, le circuit de détection de courant (100) comprenant :

des bornes d'entrée (102, 104) structurées pour recevoir une tension de sortie de l'enroulement de Rogowski (2) ;

des éléments de filtrage (106, 108) structurés pour filtrer la tension haute fréquence de la tension de sortie et pour sortir une tension de sortie filtrée ;

un amplificateur (110) structuré pour recevoir la tension de sortie filtrée et produire une tension différentielle ;

un convertisseur analogique-numérique (112) structuré pour convertir la tension différentielle en un signal de tension différentielle numérique ;

un intégrateur numérique (114) structuré pour recevoir le signal de tension différentielle numérique, pour mettre en oeuvre une fonction de transfert à temps discret qui est une transformée d'une fonction de transfert d'un intégrateur analogique et pour sortir un signal de sortie d'intégrateur numérique ;

un filtre bloqueur de courant continu (116) structuré pour supprimer une polarisation de courant continu du signal de sortie d'intégrateur numérique et pour sortir un signal de sortie de courant numérique qui est proportionnel au courant primaire dans le conducteur (8),

dans lequel la transformée à temps discret mise en oeuvre par l'intégrateur numérique (114) est une transformée d'impulsion invariante de la fonction de transfert de l'intégrateur analogique,

dans lequel l'intégrateur analogique est un filtre RC ayant une résistance R et une capacité C ; et dans lequel la fonction de transfert à temps discret de l'intégrateur numérique (114) est définie par l'équation suivante :

$$H(z) = \frac{y(z)}{x(z)} = \frac{\alpha \cdot T_S}{1 - e^{-\alpha T_S}z^{-1}} = \frac{b_0}{1 - a_1 z^{-1}}$$

$$\alpha = \frac{1}{RC}; a_1 = e^{-\alpha T_s} = e^{-\frac{T_s}{RC}}$$

où $T_s$ est un intervalle d'échantillonnage ; $\qquad\qquad\qquad\qquad$ ; $b_0 = \alpha \cdot T_s$; et $z^{-1}$ représente un retard d'un échantillon,

dans lequel l'intégrateur numérique (114) a des coefficients $a_1$ et $b_0$ ; où $a_1$ est défini par l'équation suivante :

$$a_1 = \frac{\cos(\Delta n \cdot \omega_e)}{\cos[(\Delta n - 1) \cdot \omega_e]}$$

où $b_0$ est défini par l'équation suivante :

$$b_0 = \sqrt{1 - 2a_1 \cos \omega_e + a_1^2}$$

où $\Delta n$ est le nombre d'échantillons entre le signal de sortie de courant numérique et le courant primaire dans

$$\omega_e = 2\pi \frac{f_e}{f_s}$$

le conducteur (8) ; $\qquad\qquad$ , $f_e$ est une fréquence d'alimentation nominale et $f_s$ est une fréquence d'échantillonnage du convertisseur analogique-numérique (112),

dans lequel la fréquence d'alimentation nominale est liée au courant primaire par l'équation suivante :

$$i_p(t) = A_p \cdot \sin(2\pi f_e t)$$

où $i_p(t)$ est le courant primaire, et où $A_p$ est une amplitude du courant primaire $i_p(t)$.

2. Circuit de détection de courant (100) destiné à être utilisé avec un enroulement de Rogowski (2) agencé autour d'un conducteur (8) ayant un courant primaire, le circuit de détection de courant (100) comprenant :

des bornes d'entrée (102, 104) structurées pour recevoir une tension de sortie de l'enroulement de Rogowski (2) ;

des éléments de filtrage (106, 108) structurés pour filtrer la tension haute fréquence de la tension de sortie et pour sortir une tension de sortie filtrée ;

un amplificateur (110) structuré pour recevoir la tension de sortie filtrée et produire une tension différentielle ;

un convertisseur analogique-numérique (112) structuré pour convertir la tension différentielle en un signal de tension différentielle numérique ;

un intégrateur numérique (114) structuré pour recevoir le signal de tension différentielle numérique, pour mettre en oeuvre une fonction de transfert à temps discret qui est une transformée d'une fonction de transfert d'un intégrateur analogique et pour sortir un signal de sortie d'intégrateur numérique ;

un filtre bloqueur de courant continu (116) structuré pour supprimer une polarisation de courant continu du signal de sortie d'intégrateur numérique et pour sortir un signal de sortie de courant numérique qui est proportionnel au courant primaire dans le conducteur (8),

dans lequel la transformée à temps discret mise en oeuvre par l'intégrateur numérique (114) est une transformée bilinéaire de la fonction de transfert de l'intégrateur analogique,
dans lequel l'intégrateur analogique est un filtre RC ayant une résistance R et une capacité C ; et dans lequel la fonction de transfert à temps discret de l'intégrateur numérique (114) est définie par l'équation suivante :

$$H(z) = \frac{y(z)}{x(z)} = \frac{\frac{\alpha T_s}{2+\alpha T_s} + \frac{\alpha T_s}{2+\alpha T_s}z^{-1}}{1 - \frac{2-\alpha T_s}{2+\alpha T_s}z^{-1}} = \frac{b_0 + b_1 z^{-1}}{1 - a_1 z^{-1}}$$

où $T_s$ est un intervalle d'échantillonnage ; et

$$\alpha = \frac{1}{RC}; a_1 = \frac{2-\alpha T_s}{2+\alpha T_s}, b_0 = b_1 = \frac{\alpha T_s}{2+\alpha T_s}$$

, et $z^{-1}$ représente un retard d'un échantillon,
dans lequel l'intégrateur numérique (114) a des coefficients $a_1$, $b_0$, et $b_1$ ; où $a_1$ est défini par l'équation suivante :

$$a_1 = \frac{\cos\left[\left(\Delta n + \frac{1}{2}\right) \cdot \omega_e\right]}{\cos\left[\left(\Delta n - \frac{1}{2}\right) \cdot \omega_e\right]}$$

et où $b_0$ et $b_1$ sont définis par l'équation suivante :

$$b_0 = b_1 = \sqrt{\frac{1 - 2a_1 \cos \omega_e + a_1^2}{2 \cdot (1 + \cos \omega_e)}}$$

où $\Delta n$ est le nombre d'échantillons entre le signal de sortie de courant numérique et le courant primaire dans le conducteur (8) ;

$$\omega_e = 2\pi \frac{f_e}{f_s}$$

, est une fréquence d'alimentation nominale et $f_s$ est une fréquence d'échantillonnage du convertisseur analogique-numérique (112),
dans lequel la fréquence d'alimentation nominale est liée au courant primaire par l'équation suivante :

$$i_p(t) = A_p \cdot \sin(2\pi f_e t)$$

où $i_p(t)$ est le courant primaire, et où $A_p$ est une amplitude du courant primaire $i_p(t)$.

3. Circuit de détection de courant (100) selon la revendication 1, dans lequel le filtre bloqueur de courant continu (116) a une fonction de transfert définie par l'équation suivante :

$$H(z) = \frac{y(z)}{x(z)} = \frac{b_0 + b_1 z^{-1}}{1 - a_1 z^{-1}}$$

où $0 < a_1 < 1$, $b_0 = 1$ et $b_1 = -1$.

4. Circuit de détection de courant (100) selon la revendication 1, dans lequel le filtre bloqueur de courant continu (116) est mis en oeuvre avec un filtre biquadratique numérique ayant une fonction de transfert définie par l'équation suivante :

$$H(z) = \frac{y(z)}{x(z)} = \frac{b_0 + b_1 z^{-1} + b_2 z^{-2}}{1 - a_1 z^{-1} - a_2 z^{-2}}$$

où $z^{-1}$ représente un retard d'un échantillon, $z^{-2}$ représente un retard de deux échantillons et $a_1$, $a_2$, $b_0$, $b_1$, et $b_2$

sont des coefficients.

5. Circuit de détection de courant (100) selon la revendication 4, dans lequel le filtre bloqueur de courant continu (116) est mis en oeuvre avec le filtre biquadratique numérique ; et dans lequel $a_1 \neq 0$, $a_2 = 0$, $b_0 = 1$, $b_1 = -1$ et $b_2 = 0$.

6. Circuit de détection de courant (100) selon la revendication 1, dans lequel les éléments de filtrage (106, 108) incluent au moins une perle de ferrite.

7. Procédé de mise en oeuvre d'un intégrateur numérique (114), le procédé comprenant de :

fournir une fréquence d'échantillonnage $f_s$ ;
fournir une fréquence d'alimentation nominale $f_e$ ;
fournir un nombre $\Delta$n d'échantillons entre un signal de sortie de courant numérique proportionnel à un courant primaire dans un conducteur (8) et le courant primaire dans le conducteur (8) ;
obtenir la fréquence angulaire normalisée d'un réseau électrique à l'état nominal en utilisant l'équation suivante :

$$\omega_e = 2\pi \frac{f_e}{f_s}$$

obtenir un premier coefficient $a_1$ sur la base de l'équation suivante :

$$a_1 = \frac{\cos(\Delta n \cdot \omega_e)}{\cos[(\Delta n - 1) \cdot \omega_e]}$$

obtenir un second coefficient sur la base de l'équation suivante :

$$b_0 = \sqrt{1 - 2a_1 \cos \omega_e + a_1^2}$$

mettre en oeuvre l'intégrateur numérique (114) en tant que filtre numérique en mettant en oeuvre une fonction de transfert à temps discret en utilisant le premier coefficient $a_1$ et le second coefficient $b_0$,
dans lequel la fonction de transfert à temps discret est une transformée d'impulsion invariante d'une fonction de transfert d'un intégrateur analogique,
dans lequel l'intégrateur analogique est un filtre RC ayant une résistance R et une capacité C,
dans lequel la fonction de transfert à temps discret est définie par l'équation suivante :

$$H(z) = \frac{y(z)}{x(z)} = \frac{\alpha \cdot T_S}{1 - e^{-\alpha T_S} z^{-1}} = \frac{b_0}{1 - a_1 z^{-1}}$$

où $T_s$ est un intervalle d'échantillonnage ;

$$\alpha = \frac{1}{RC}; \ a_1 = e^{-\alpha T_s} = e^{-\frac{T_s}{RC}}$$

; $b_0 = \alpha \cdot T_s$ ; et $z^{-1}$ représente un retard d'un échantillon,
dans lequel la fréquence d'alimentation nominale est liée au courant primaire dans le conducteur (8) par l'équation suivante :

$$i_p(t) = A_p \cdot \sin(2\pi f_e t)$$

où $i_p(t)$ est le courant primaire dans le conducteur (8) et où $A_p$ est une amplitude du courant primaire dans le conducteur $i_p(t)$.

8. Procédé de mise en oeuvre d'un intégrateur numérique (114), le procédé comprenant de :

fournir une fréquence d'échantillonnage $f_s$ ;
fournir une fréquence d'alimentation nominale $f_e$ ;
fournir un nombre $\Delta$n d'échantillons entre un signal de sortie de courant numérique proportionnel à un courant primaire dans un conducteur (8) et le courant primaire dans le conducteur (8) ;
obtenir la fréquence angulaire normalisée d'un réseau électrique à l'état nominal en utilisant l'équation suivante :

$$\omega_e = 2\pi \frac{f_e}{f_s}$$

obtenir un premier coefficient $a_1$ sur la base de l'équation suivante :
obtenir un deuxième coefficient $b_0$ et un troisième coefficient $b_1$ sur la base de l'équation suivante :

$$b_0 = b_1 = \sqrt{\frac{1 - 2a_1 \cos \omega_e + a_1^2}{2 \cdot (1 + \cos \omega_e)}}$$

mettre en oeuvre l'intégrateur numérique (114) en tant que filtre numérique en mettant en oeuvre une fonction de transfert à temps discret en utilisant le premier coefficient $a_1$, le deuxième coefficient $b_0$ et le troisième coefficient $b_1$,
dans lequel la fonction de transfert à temps discret est une transformée bilinéaire d'une fonction de transfert d'un intégrateur analogique,
dans lequel l'intégrateur analogique est un filtre RC ayant une résistance R et une capacité C,
dans lequel la fonction de transfert à temps discret de l'intégrateur numérique (114) est définie par l'équation suivante :

$$H(z) = \frac{y(z)}{x(z)} = \frac{\frac{\alpha T_s}{2 + \alpha T_s} + \frac{\alpha T_s}{2 + \alpha T_s} z^{-1}}{1 - \frac{2 - \alpha T_s}{2 + \alpha T_s} z^{-1}} = \frac{b_0 + b_1 z^{-1}}{1 - a_1 z^{-1}}$$

$$\alpha = \frac{1}{RC}; \ a_1 = \frac{2 - \alpha T_s}{2 + \alpha T_s}, \ b_0 = b_1 = \frac{\alpha T_s}{2 + \alpha T_s}$$

où $T_s$ est un intervalle d'échantillonnage ;                                          , et $z^{-1}$ représente un retard d'un échantillon,
dans lequel la fréquence d'alimentation nominale est liée au courant primaire dans le conducteur (8) par l'équation suivante :

$$i_p(t) = A_p \cdot \sin(2\pi f_e t)$$

où $i_p(t)$ est le courant primaire dans le conducteur (8) et où $A_p$ est une amplitude du courant primaire $i_p(t)$.

*FIG.1*

INSTRUMENTATION
AMPLIFIER

$V_R(t)$

$V_0(t)$

C

R/2

R/2

FB1

FB2

*FIG.2*

100

INSTRUMENTATION
AMPLIFIER

$V_R(t)$

FB1

FB2

$V'_R(t)$

IN    OUT

ANALOG-TO-DIGITAL
CONVERTER

$V_R[n]$

H(z)

DIGITAL
INTEGRATOR

$V_D[n]$

H'(z)

DC BLOCKER
FILTER

$i_Q[n]$

*FIG.3*

*FIG.4*

*FIG.5*

*FIG.6*

*FIG.7A*

*FIG.7B*

*FIG.7C*

*FIG.7D*

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102012107021 A1
- DE 102015216981 A1
- WO 0182675 A2
- US 6624745 B1

**Non-patent literature cited in the description**

- **FAIFER M et al.** An Electronic Current Transformer Based on Rogowski Coil. *TECHNOLOGY CONFERENCE,* 12 May 2008, ISBN 978-1-4244-1540-3